(19) Europäisches Patentamt / European Patent Office / Office européen des brevets

(11) **EP 4 531 060 A1**

(12) **EUROPEAN PATENT APPLICATION**
published in accordance with Art. 153(4) EPC

(43) Date of publication:
**02.04.2025  Bulletin 2025/14**

(21) Application number: **23812076.0**

(22) Date of filing: **19.05.2023**

(51) International Patent Classification (IPC):
**H01B 7/08** (2006.01)      **H05K 1/14** (2006.01)
**H01B 13/00** (2006.01)

(52) Cooperative Patent Classification (CPC):
**H01B 7/08; H01B 13/00; H05K 1/14**

(86) International application number:
**PCT/KR2023/006851**

(87) International publication number:
**WO 2023/229302 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  **23.05.2022  KR 20220062912**

(71) Applicant: **Samwon Act Co., Ltd.**
**Busan 47035 (KR)**

(72) Inventors:
• **LEE, Kyung Yul**
  **Bucheon-si Gyeonggi-do 14665 (KR)**
• **KIM, Man**
  **Changwon-si Gyeongsangnam-do 51170 (KR)**
• **CHOI, Kwang Jong**
  **Ansan-si Gyeonggi-do 15347 (KR)**
• **CHOI, Eun Yoo**
  **Suwon-si Gyeonggi-do 16295 (KR)**
• **PARK, Hwa Sun**
  **Suwon-si Gyeonggi-do 16697 (KR)**

(74) Representative: **Cabinet Chaillot**
**16/20, avenue de l'Agent Sarre**
**B.P. 74**
**92703 Colombes Cedex (FR)**

(54) **LOW-LOSS FLAT CABLE SIGNAL LINE FOR ULTRA-HIGH FREQUENCY, FLEXIBLE PRINTED CIRCUIT BOARD USING SAME, AND FLEXIBLE PRINTED CIRCUIT BOARD CONTINUOUS MANUFACTURING DEVICE**

(57)    The present invention has the following configuration. The present invention relates to a low-loss flat cable signal line for an ultra-high frequency, wherein the signal line plated, by a manufacturing method using an electroplating bath, on a micro circuit pattern part formed in a cylindrical circuit mold configured in the electroplating bath is configured to have an arc-shaped cross section or oval-shaped cross section, and a ratio ($\alpha$=a/b) between an electroplated line width (b) and a micro circuit pattern part line width (a) is 0.3 or less.

[FIG.1]

START
→ PHOTORESIST INK APPLICATION STEP — S100
→ PHOTOMASK CONFIGURATION STEP — S200
→ DEVELOPMENT AND CURING STEP — S300
→ ETCHING STEP — S400
→ PHOTORESIST INK REMOVAL STEP — S500
→ MASKING AGENT APPLICATION STEP — S600
→ MASKING AGENT BAKING STEP — S700
→ POLISHING STEP — S800
→ END

**EP 4 531 060 A1**

**Description**

[Technical Field]

The invention of the present application is achieved by analyzing, in terms of transmission loss, a difference between a shape of a cross section of a pattern formed by an existing FPCB manufacturing process and a shape of a cross section of a pattern formed by a micro pattern transfer printing (MPTP) process technology of the present invention. An arch type manufactured by the MPTP process technology of the present invention is obtained by analyzing a shape of a cross section enabling transmission loss to be minimized at a high frequency.

[Background Art]

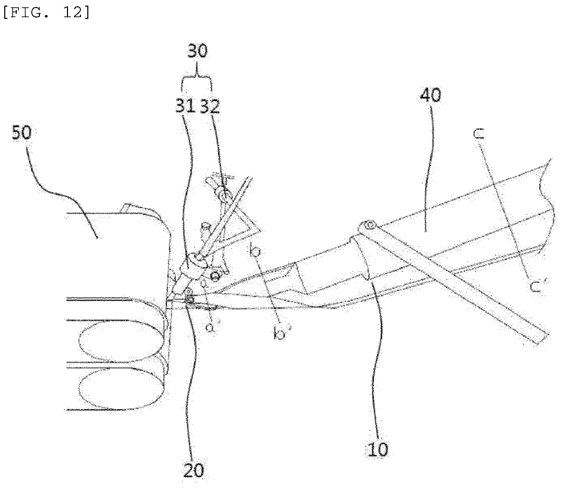

As seen in FIG. 12 of the background art, a raw material 10 is formed in a strip shape of a required size. The raw material 10 is made of a foamed material such as polyethylene or polyurethane and can be made of any material as long as the raw material 10 can efficiently protect a wire, a cable, a pipe, or the like that is covered with the raw material 10. The raw material 10 is formed at a longer length than the following manufactured resulting product, since the length of the raw material 10 may decrease or increase due to heat applied during a process of forming the following resulting product. The raw material 10 is put into dies 20 and is changed in shape. The raw material 10 has, as a cross-section shape, a linear shape at a c-c' position, a semicircular shape at a b-b' position, and a circular shape at an a-a' position.

Next, the dies 20 are prepared.

Specifically, the dies 20 are formed in a shape in which, except for a part of a tubular member, the rest thereof on one side is open and unrolled. That is, the dies 20 include an outlet 22 that maintains a tubular shape and an inlet that is open and unrolled in one direction.

The strip-shaped raw material 10 is fed into the inlet and deformed such that both longitudinal ends of the raw material 10 meet each other. When the ends are joined by the following sealing unit 30 and pass through the outlet, a resulting product in a tubular shape is manufactured.

The dies 20 can be formed to have various sizes depending on characteristics of the raw material 10 and a desired resulting product and can be formed in any shape as long as the strip-shaped raw material 10 can pass through the dies to be formed in the tubular shape.

Specifically, the sealing unit 30 is provided above the dies 20 and is installed in a direction toward the dies 20.

The sealing unit 30 fulfills a function of applying heat to both the ends of the raw material 10 that are in contact with each other and bonding the ends to each other. The sealing unit 30 performs heating at different temperatures depending on materials of which the raw material 10 is made. The heating is performed at high temperature in a case where the raw material 10 is made of polyurethane, and the heating is performed at low temperature in a case where the raw material 10 is made of polyethylene. Polyethylene can bond at low temperature, while polyurethane requires high temperature heating for bonding. The sealing unit 30 includes a heater 31 and a position adjuster 32.

The heater 31 is installed toward the raw material 10 and applies heat to both the ends of the raw material 10 that are in contact with each other. The heater 31 uses a coil that generates heat by electricity and hot air produced using air.

The position adjuster 32 is installed on one side of the heater 31 and serves to adjust the position of the heater 31. That is, the position adjuster 32 serves to adjust the position of the heater 31 which varies depending on a width and a thickness of the raw material 10.

Next, a heat supply unit 40 is provided on one side of the dies 20.

Specifically, the heat supply unit 40 is installed in a direction toward the raw material 10 passing through the dies 20 and serves to supply heat to the raw material 10. The heat supply unit 40 serves to supply heat to the raw material 10, aiding in deformation of the raw material 10 into a tubular shape, and aiding in bonding of both the ends of the raw material 10 by heat and maintaining of the bonding.

Next, a conveyor unit 50 is provided on one side of the dies 20.

Specifically, the conveyor unit 50 is provided in a direction of the outlet of the dies 20. The conveyor unit 50 includes upper and lower conveyor belts formed separately, and the conveyor belts are installed to rotate in opposite directions from each other. The conveyor unit 50 serves to move the resulting product discharged through the outlet 22 in a direction opposite to the dies 20.

In order to transmit a signal in an ultra-high frequency range, there is a demand for a flexible printed circuit board configured of micro pattern signal lines through an electroforming process to reduce weight of the flexible printed circuit board and reduce transmission loss.

The present invention has emerged under such circumstances.

[Summary of Invention]

[Technical Problem]

A first challenge to be solved by the invention is to solve a challenge of enabling a cost reduction of 40% to 50% through process reduction during manufacturing a circuit, by using a cylindrical mold of micro pattern for electroforming.

A second challenge to be solved by the invention is to solve a challenge of providing advantages in terms of cost reduction and environmental friendliness by using an MPTP process in which no etchant is used compared to the existing technologies by using an electroforming process instead of etching compared to a case of a process using the existing wet etching which causes material consumption and an environmental burden due to toxic chemicals used in etching.

A third challenge to be solved by the invention is to solve a challenge of enabling a thickness or a shape of a cross section of a signal line to be adjusted to be suitable for product characteristics and enabling various materials such as copper and alloys to be selected as a material of the signal line, by manufacturing the signal line through an electroforming process.

A fourth challenge to be solved by the invention is to solve a challenge of enabling roughness of a circuit adhesive surface of a cross section of a circuit manufactured by an MPTP process to be reduced and a shape of a plated and grown cross section thereof to be controlled compared to a cross section of a circuit formed by the existing wet etching process technology such that transmission loss in a high frequency band can be reduced.

A fifth challenge to be solved by the invention is to solve a challenge of also enabling a flexible printed circuit board having a long circuit length to be manufactured by selecting various film bases.

A sixth challenge to be solved by the invention is to solve a challenge of enabling a signal line to be formed on any material including a soft flexible material and any thickness thereof.

[Solution to Problem]

The present invention has the following configuration to solve the challenges.

The present invention relates to a low-loss flat-cable signal line for ultra-high frequency manufactured to have an arch-type or ellipse-type cross section of a circuit plating layer plated on a microcircuit pattern section formed on a cylindrical mold of micro pattern provided in an electroforming bath.

Here, the circuit plating layer has the arch-type or ellipse-type cross section, and a ratio ($\alpha = a/b$) of a line width a of the microcircuit pattern section to an electroformed line width b is 0.3 or lower.

Here, preferably, the electroformed line width b is 10 $\mu$m to 500 $\mu$m, and roughness Ra is 1 $\mu$m or lower.

Preferably, a cross section of a circuit plating layer plated on a microcircuit pattern section formed on a cylindrical mold of micro pattern provided in an electroforming bath is ellipse-type,

a thickness of the cross section of the circuit plating layer is defined as a distance h from a surface of the cylindrical mold of micro pattern to an upper end of the cross section of the circuit plating layer, and
in a case where a length from a front surface of the cylindrical mold of micro pattern to a major axis of an ellipse is defined as h2, and a distance from the major axis of the ellipse to the upper end of the cross section of the circuit plating layer is defined as h1, a ratio of h1/h2 is between 0.5 and 1.

Here, the distance h from the surface of the cylindrical mold of micro pattern to the upper end of the cross section of the circuit plating layer is 5 $\mu$m to 100 $\mu$m, and roughness Ra is 1 $\mu$m or lower.

A flexible printed circuit board for a flat cable for ultra-high frequency includes a microstrip structure in which the low-loss flat-cable signal line for ultra-high frequency is bonded to a base film, and a metal layer (ground) having a grounding function is attached to a back surface of the base film to which the low-loss flat-cable signal line for ultra-high frequency is attached.

A flat-cable flexible printed circuit board for ultra-high frequency continuous-manufacturing device has a configuration in which, in order to manufacture the flat-cable flexible printed circuit board for ultra-high frequency, the cylindrical mold of micro pattern is partially submerged in the electroforming bath, the low-loss flat-cable signal line for ultra-high frequency is plated on the microcircuit pattern section, and plated the low-loss flat-cable signal line for ultra-high frequency is transferred and printed onto the base film by passing, between the cylindrical mold of micro pattern and a pressing roller, the base film on which an adhesive is applied.

Preferably, the low-loss flat-cable signal line for ultra-high frequency is configured to have an arch-type or ellipse-type cross section depending on a magnitude of a current flowing in the electroforming bath and a rotation speed of the cylindrical mold of micro pattern by the flat-cable flexible printed circuit board for ultra-high frequency continuous-manufacturing device.

Preferably, the low-loss flat-cable signal line for ultra-high frequency is configured to have an arch-type or ellipse-type cross section by adding a leveler and an additive in the electroforming bath by the flat-cable flexible printed circuit board for ultra-high frequency continuous-manufacturing device.

A method for forming a micro pattern on a metal plate of the cylindrical mold of micro pattern in order to manufacture the flat-cable flexible printed circuit board for ultra-high frequency continuous-manufacturing device includes:

a photoresist ink application step of applying photoresist ink on the metal plate;
a photomask configuration step of forming a photomask after the photoresist ink application step;
a development and curing step of developing and curing a photoresist by exposure after the photomask configuration step;
an etching step of etching metal with an etchant in a developed region after the development and curing step;
a photoresist removal step of removing the cured photoresist after the etching step;
a masking agent application step of applying a masking agent after the photoresist removal step;
a masking agent baking step of baking the masking agent after the masking agent application step; and
a polishing step of performing polishing while a part of the metal plate in which a microcircuit pattern section is formed is protected, after the masking agent baking step.

[Advantageous Effects of Invention]

The invention has, as a first effect, an effect in that process reduction can be achieved during circuit manufacturing since a cylindrical mold 100 of micro pattern is used.

The invention achieves, as a second effect, an effect of cost reduction of 40 to 50% compared to the existing technologies and an advantage in terms of environmental friendliness without using an etchant since continuous production is performed by the cylindrical mold of micro pattern when an MPTP process is used instead of etching, compared to a case of a process using the existing wet etching which causes material consumption and an environmental burden due to toxic chemicals used in etching.

The invention has, as a third effect, an effect in that a thickness or a shape of a cross section of a signal line can be adjusted to be suitable for product characteristics and various materials such as copper and alloys can be selected as a material of the signal line, by manufacturing the signal line through an electroforming process.

The invention has, as a fourth effect, an effect in that roughness of a circuit adhesive surface of a cross section of a circuit manufactured by the MPTP process can be lowered compared to a cross section of a circuit formed by the existing PCB process technology such that transmission loss in a high frequency band can be reduced.

The invention has, as a fifth effect, an effect in that a flexible printed circuit board having a long circuit length can be manufactured.

The invention has, as a sixth effect, an effect in that film layers 400 made of various soft materials and thicknesses can be easily replaced, and thus the invention is applicable in various fields.

[Brief Description of Drawings]

FIG. 1 is a flowchart related to a method for forming a micro pattern on a cylindrical mold of micro pattern.
FIG. 2A is a view on a plane for easy understanding of the method for forming a micro pattern on the cylindrical mold of micro pattern.
FIG. 2B is a view illustrating the cylindrical mold of micro pattern on which a microcircuit pattern is formed through the process of FIG. 2A.
FIG. 3A is a view illustrating a flat-cable flexible printed circuit board for ultra-high frequency manufacturing device of the invention of the present application.
FIG. 3B is a view illustrating a cross section of an arch-type circuit plating layer that has been plated and grown on the cylindrical mold of micro pattern.
FIG. 3C is, as an actual view with respect to FIG. 3B, a view illustrating the cross section of the arch-type circuit plating layer that has been plated and grown.
FIG. 3D is a view illustrating a cross section of an ellipse-type signal line that has been plated and grown on a cylindrical mold of micro pattern.
FIG. 3E is, as an actual view with respect to FIG. 3D, a view illustrating the cross section of the ellipse-type signal line which is a plating layer.
FIG. 4A is a view illustrating a cross-sectional view of a flat-cable flexible printed circuit board for ultra-high frequency of the present invention and illustrating that a shape of the signal line is an arch type.

FIG. 4B is a view illustrating a cross-sectional view of the flat-cable flexible printed circuit board for ultra-high frequency of the present invention and illustrating that the shape of the signal line is an ellipse type.

FIG. 4C is a view illustrating a state in which the signal line is attached to a film layer of the present invention and illustrating a flat-cable flexible printed circuit board for ultra-high frequency in a simulation.

FIG. 4D is a view illustrating a cross-sectional view of the flat-cable flexible printed circuit board for ultra-high frequency in the simulation.

FIG. 5 is a view illustrating a structure of a cross section by the existing FPCB.

FIG. 6 is a view illustrating the flat-cable flexible printed circuit board for ultra-high frequency made by the manufacturing device of the present invention.

FIG. 7 is a view illustrating a shape of a cross section of a circuit plating layer according to a size of a parameter $\alpha$ by the simulation.

FIG. 8 is a graph illustrating transmission loss depending on a frequency according to the parameter $\alpha$ by the simulation.

FIGS. 9A and 9B are views illustrating a growth model based on a pattern plating cross section depending on an addition amount of a leveler.

FIGS. 10A to 10C are views illustrating a growth shape of a copper plating layer in a case where a magnitude of a current and a rotation speed are varied in an electroforming bath.

FIGS. 11A to 11C are views illustrating changes in copper plating thickness and shape of a cross section depending on a plating time.

FIG. 12 is a view illustrating the background art.

[Description of Embodiments]

Recently, there is a growing demand for not only compactness, high integration, high functionality, and high speed, but also environmental friendliness and cost reduction of an electronic component.

In particular, the demand for the above-described qualities for an electronic component applied in an electric vehicle is increasing even more. Recently, among components applied to electric vehicles, a cable harness used for power and signal transmission is a technology of great interest aimed at improving lightweight design and space-saving.

Attention is attracted to a study of replacing the coaxial cables of the existing cable harness with flexible printed circuit boards (FPCBs).

Replacement of the cable harness used in a car with the FPCBs can significantly reduce weight of wiring connected inside a vehicle, thereby being expected to improve fuel efficiency.

In particular, the FPCB is a flexible electric circuit board and can be bent more freely by configuring the existing stiff printed circuit boards (PCBs) of a base film made of thin and flexible polyimide or polyester.

The materials described above are much lighter than other materials, thus enabling an electronic product to become compact in size and lightweight.

The materials are also advantageous in that the materials can withstand a higher temperature compared to other materials and can withstand an extreme temperature between 200 and 400 degrees Celsius.

Currently, these characteristics allow the FPCB to be used as one of the electronic components used in almost all electronic products, such as a mobile phone and a laptop. However, since the existing FPCB process needs to be executed through a complex process of applying a photoresist on a polyimide film coated with copper foil and performing exposure, development, and drying each time a circuit is manufactured, the existing FPCB has limitations on productivity and manufacturing costs.

The present invention provides a new type of technology with which the process technology for manufacturing the existing FPCBs can be replaced.

The technology proposed in the present invention is micro pattern transfer printing (MPTP). The MPTP is a method for manufacturing an FPCB by forming a microcircuit only on a circuit part formed on a cylindrical mold 100 of micro pattern and then transferring the microcircuit to an adhesive layer 500 attached to a base film 400.

Advantages of manufacturing the FPCB by using the invention of the present application are as follows.

First, process reduction can be achieved during manufacturing a signal line since the cylindrical mold 100 of micro pattern is used.

Secondly, it is possible to solve material consumption and environmental issues with respect to chemicals or the like used for etching in the case of a process using the existing wet etching.

However, when a micro pattern transfer printing (MPTP) technology is used, continuous production is achieved by the cylindrical mold 100 of micro pattern instead of etching, an effect of a cost reduction of 40-50% is achieved compared to the existing technologies, and the technology has an advantage of environmental friendliness in that no etchant is used.

Thirdly, an advantage is achieved in that roughness of a signal line adhesive surface of a cross section of a signal line manufactured by the MPTP technology can be lowered compared to a cross section of a signal line formed by the existing PCB process technology such that transmission loss in a high frequency band can be reduced.

When a signal line is manufactured by an electroforming technology, the roughness can be adjusted to 1 $\mu$m or lower. In the existing etching process, a copper foil surface needs to have roughness Ra of 5 $\mu$m to 10 $\mu$m in order to bond copper foil to a film.

Finally, it is possible to manufacture a flat cable having a long signal line.

A circuit plating layer 115 is a name for one unit of the cylindrical mold of micro pattern, and the signal line is named for a plurality of circuit plating layers formed on the cylindrical mold of micro pattern based on the premise that the circuit plating layers are arranged on the base film. Hence the circuit plating layers and the signal line basically denote the same object.

The circuit plating layer 115 of the cylindrical mold of micro pattern is eventually based on the premise of being attached to the base film 400 to be used as the signal line.

First, the cylindrical mold 100 of micro pattern is formed.

In order to perform electroforming on the cylindrical mold 100 of micro pattern, the cylindrical mold 100 of micro pattern is partially submerged in an electroforming bath 200, and a microcircuit pattern section 160 of the cylindrical mold 100 of micro pattern submerged in the electroforming bath 200 is plated with the circuit plating layer 115 formed from the electroforming bath 200.

In the invention of the present application, the circuit plating layer 115 denotes the signal line used for a flat-cable flexible printed circuit board for ultra-high frequency.

The cylindrical mold 100 of micro pattern adjusts a rotation speed to form the circuit plating layers 115.

The invention is made to provide a low-loss flat-cable signal line for ultra-high frequency manufactured to have an arch-type or ellipse-type cross section of the circuit plating layer plated on the microcircuit pattern section 160 formed on the cylindrical mold 100 of micro pattern provided in the electroforming bath 200 such that a configuration of a signal line for ultra-high frequency signal transmission is provided and transmission loss is minimized.

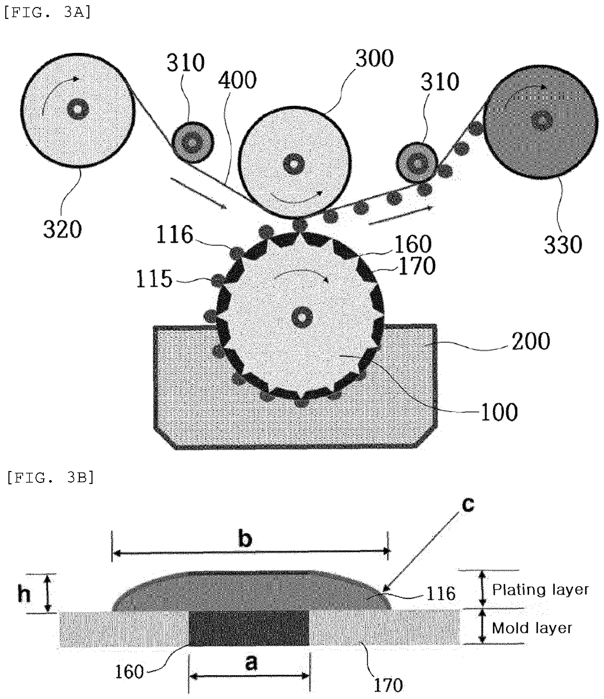

The description according to FIG. 3A is as follows.

The generated circuit plating layers 115 are continuously transferred by a pressing roller 300 from the cylindrical mold 100 of micro pattern to the adhesive layer 500 formed on the base film 400 passing the circuit plating layers 115. In this manner, a signal line through which a signal in an ultra-high frequency range of 3 GHz to 30 GHz is transmitted is manufactured.

There is provided a flat-cable flexible printed circuit board for ultra-high frequency continuous-manufacturing device manufactured to form, in an arch-type or ellipse-type shape, a cross section 116 of the circuit plating layer corresponding to a cross section of the signal line to minimize a loss rate of the signal line.

That is, in order to manufacture the flat-cable flexible printed circuit board for ultra-high frequency, the cylindrical mold 100 of micro pattern is partially submerged in the electroforming bath 200, the circuit plating layer 115 is plated on the microcircuit pattern section 160, and the plated circuit plating layer 115 is transferred and printed onto the base film 400 on which the adhesive layer 500 is formed by passing, between the cylindrical mold 100 of micro pattern and the pressing roller 300, the base film 400 on which an adhesive is applied.

In GIGA frequency bands commonly used in 5G and 6G, a transmission loss rate becomes the biggest issue when a signal is transmitted.

In particular, the invention of the present application is applied to reduce a loss rate in a frequency band of 3 GHz to 30 GHz which is an ultra-high frequency band.

An electroformed line width b of the microcircuit pattern section 160 formed on the cylindrical mold 100 of micro pattern provided in the electroforming bath 200 by a manufacturing method using the electroforming bath is 10 $\mu$m to 500 $\mu$m, and a thickness h thereof is 5 $\mu$m to 100 $\mu$m.

It is possible to configure a low-loss flat-cable signal line for ultra-high frequency having the roughness Ra of 1 $\mu$m or lower.

Preferably, the cross section 116 of the circuit plating layer has the arch-type or ellipse-type shape, and a ratio ($\alpha$ = a/b) of a line width a of the microcircuit pattern section to the electroformed line width b is 0.3 or lower.

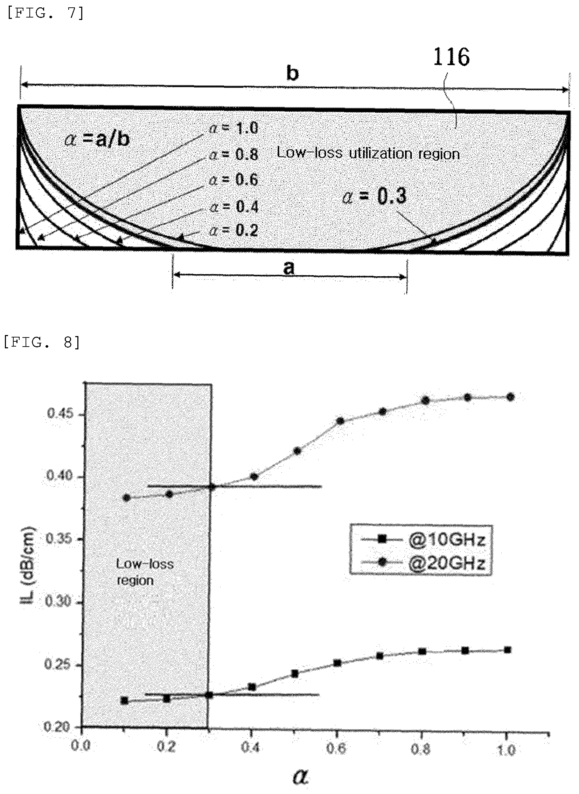

This is described and illustrated in Table 1 and FIG. 7 in detail.

The circuit plating layer 115 is plated on the microcircuit pattern section 160 of the cylindrical mold 100 of micro pattern provided in the electroforming bath 200 and adheres to the base film 400 having a desired length.

The circuit plating layers 115 are continuously transferred by the pressing roller 300 to the adhesive layer 500 formed on a surface of the base film 400.

The shape of the cross section of the transferred signal line includes an arch type or an ellipse type.

A parameter $\alpha$, which affects the transmission loss rate, is as described above.

In the configuration, $\alpha$ is set to be lower than 1 so that the transmission loss rate is decreased when an ultra-high frequency signal is transmitted. More preferably, $\alpha$ is set to 0.3 or lower such that the transmission loss rate is decreased.

FIG. 8 illustrates a graph curve bent at $\alpha$ = 0.3.

It can be found that the transmission loss rate is significantly higher in a 20 GHz frequency band than in a 10 GHz frequency band by an α value.

The flat-cable flexible printed circuit board for ultra-high frequency includes a microstrip structure in which the low-loss flat-cable signal line for ultra-high frequency is bonded to the base film 400, and a metal layer(ground) having a grounding function of protecting a signal from external noise is attached to a back surface of the base film 400 to which the low-loss flat-cable signal line for ultra-high frequency is attached.

FIG. 3A illustrates a process of manufacturing the flat-cable flexible printed circuit board for ultra-high frequency in which the circuit plating layer 115 electroformed on the microcircuit pattern section 160 of the cylindrical mold 100 of micro pattern is subjected to transferred printing onto the adhesive layer 500 formed on the base film 400.

The existing manufacturing of etched FPCB microcircuit pattern sections is performed using expensive equipment and complex processes of PR coating, exposure, development, baking, etching, and the like of the base film or a resin to which a copper foil film is attached by a photo chemical machining (PCM) process each time a pattern is formed.

However, this technology does not use the photo chemical machining (PCM) process each time a pattern is manufactured, but can manufacture the cylindrical mold 100 of micro pattern on which a circuit, a mesh, or a pattern is formed in a single photo chemical machining (PCM) process. The microcircuit pattern section 160 is formed on the formed cylindrical mold 100 of micro pattern by an electroforming process.

The circuit plating layers 115 corresponding to the microcircuit pattern sections 160 can be continuously and repeatedly manufactured by transferring the circuit plating layers 115 plated on the microcircuit pattern sections 160 of the cylindrical mold 100 of micro pattern to the base film 400 made of a soft material to which the adhesive layer 500 is attached.

The microcircuit pattern sections 160 have the circuit plating layers 115 in the electroforming bath 200 due to a continuous repetitive transfer process. This enables massive production of signal lines 117 to be performed with low costs. By manufacturing the signal line 117 by the electroforming process, it is easy to control the thickness, and it is also possible to manufacture a signal line including a multilayer plating layer or alloy plating layer signal line.

A cross section of a circuit formed by the micro pattern transfer printing (MPTP) process in FIG. 3A has a different structure compared to the cross section formed by the existing etching FPCB process. A cross section of a circuit formed on the base film 400 has a characteristic of being subjected to the transferred printing from the cylindrical mold 100 of micro pattern by the micro pattern transfer printing (MPTP) process, and the cross section has the arch-type or ellipse-type shape.

The circuit plating layer 115 is formed on the cylindrical mold 100 of micro pattern by the electroforming process, thus having an arch-type or ellipse-type shape.

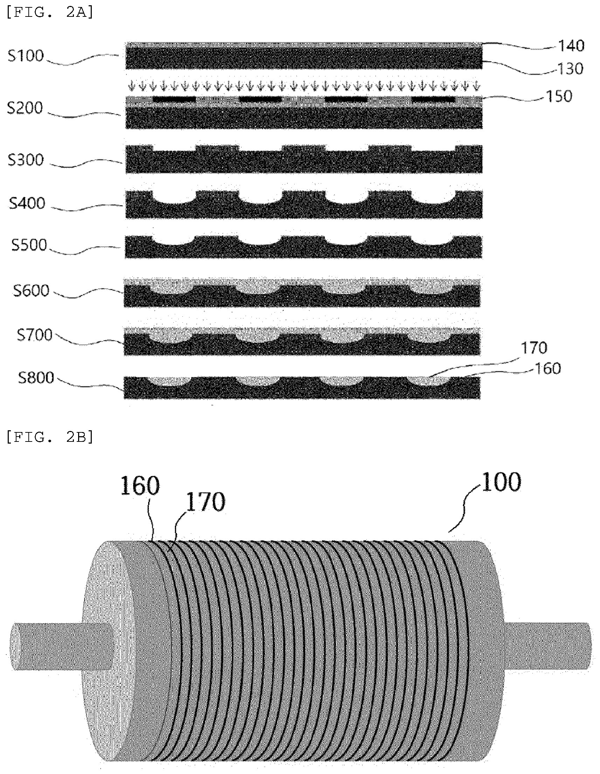

The cylindrical mold 100 of micro pattern includes an insulator 170 between the microcircuit pattern sections 160. As seen in FIG. 2, the insulator is made of polymer resin.

The microcircuit pattern section 160 allows the circuit plating layer 115 to be formed thereon inside the electroforming bath 200.

The base film 400 to which the adhesive layer 500 is attached receives the circuit plating layer 115 plated in the cylindrical mold 100 of micro pattern by the pressing roller 300.

In the configuration in which a film supply roller 320 and a film receiving roller 330 are provided and idle rollers 310 are arranged between the cylindrical mold 100 of micro pattern and the rollers, respectively, such that the base film 400 receives the circuit plating layers 115 transferred from the cylindrical mold 100 of micro pattern with suitable tension.

The invention can be applied in fields in which it is difficult to perform manufacturing by the existing photo chemical machining (PCM) process.

The base film can be easily applied in various fields without being limited to the polyimide film, unlike the etched FPCB since types and thicknesses of the base film 400 made of a soft material can be easily replaced.

The description according to FIGS. 3B to 3F is as follows.

FIGS. 3B to 3C illustrate the cross section of the circuit plating layer having the arch type.

The drawings are views illustrating a case where the line width of the microcircuit pattern section is set to a and the electroformed line width is set to b.

The formed and grown metal grows in a flat state in which an immediately upper section of the metal corresponding to the line width a of the microcircuit pattern section 160 has little curvature radius.

The immediately upper section of the line width a grows in a shape that is almost parallel to a mold pattern surface.

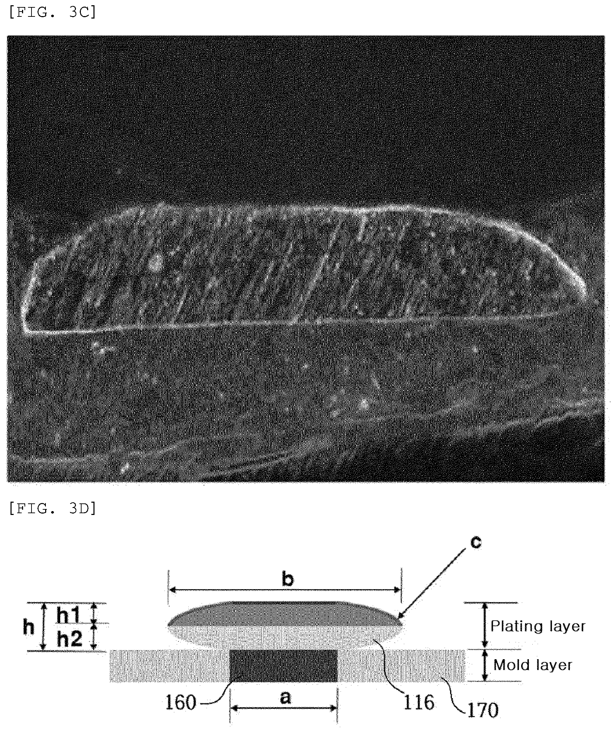

FIG. 3C is a view illustrating a cross section of the circuit plating layer 115 which is an actual plating layer that has been plated and grown.

FIG. 3D is a view illustrating a cross section of the ellipse-type circuit plating layer 115 that has been plated and grown on a cylindrical mold of micro pattern.

The line width a corresponds to a line width of a mold pattern.

In the drawing, b corresponds to the electroformed line width.

In the drawing, c indicates an arch-type plating growth surface.

In the drawing, h is a thickness of an arch-type coating layer.

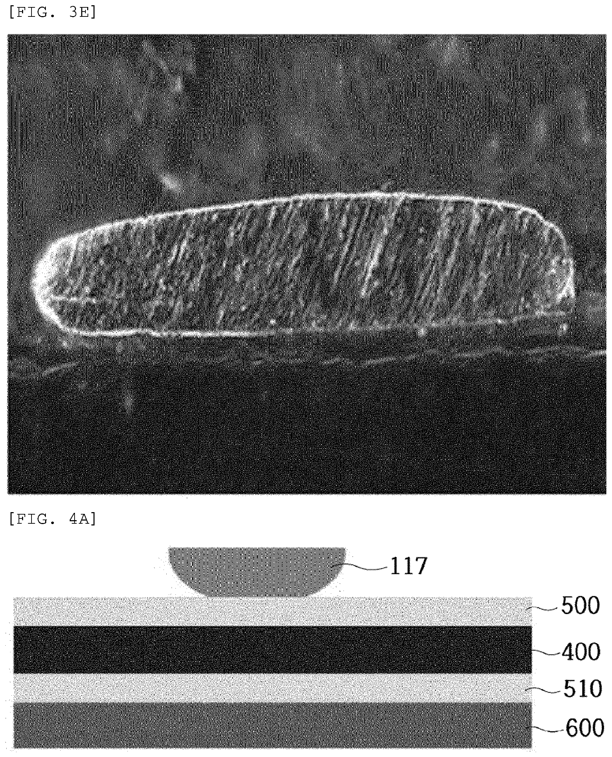

FIG. 3E is a view illustrating a cross section of the circuit plating layer 115 which is an actual plating layer in FIG. 3D.

The circuit plating layer 115 plated on the microcircuit pattern section 160 formed on the cylindrical mold 100 of micro pattern provided in the electroforming bath 200 has an ellipse-type cross section.

A thickness of the cross section of the circuit plating layer 115 is defined as a distance h from a surface of the cylindrical mold of micro pattern to an upper end of the cross section of the signal line.

In a case where a height from the surface of the cylindrical mold of micro pattern to a major axis of the ellipse is defined as h2, and a distance from the major axis of the ellipse to the upper end of the cross section is defined as h1, the low-loss flat-cable signal line for ultra-high frequency is configured such that a ratio of h1/h2 is between 0.5 and 1.

A method for manufacturing the flexible printed circuit board is performed by the flexible printed circuit board manufacturing device to allow the circuit plating layer to have the arch-type or ellipse-type cross section depending on a magnitude of a current flowing in the electroforming bath and a rotation speed of the cylindrical mold of micro pattern.

FIG. 4A is a view illustrating a cross-sectional view of the flat-cable flexible printed circuit board for ultra-high frequency of the present invention and illustrating a state in which the signal line 117 has an arch-type cross section.

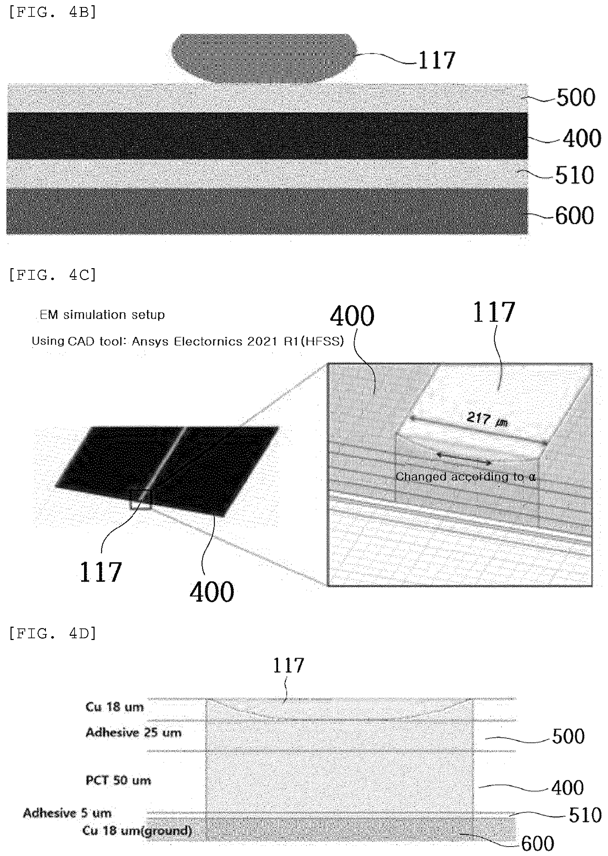

FIG. 4B is a view illustrating a cross-sectional view of the flat-cable flexible printed circuit board for ultra-high frequency of the present invention and illustrating a state in which the signal line 117 has an ellipse-type cross section.

FIG. 4C is a view illustrating a flat-cable flexible printed circuit board for ultra-high frequency in a simulation with a state in which the signal line is attached to a film layer of the present invention.

FIG. 4D is a view illustrating a cross-sectional view of the flat-cable flexible printed circuit board for ultra-high frequency in the simulation.

When the FPCB is manufactured using the micro pattern transfer printing (MPTP) process described above, a cross section thereof can have a shape having three layers.

A lower adhesive layer 510 and a second metal layer 600 can be optionally further formed.

In the drawings and descriptions, poly cyclohexylenedimethylene terephthalate (PCT) is used as a flexible film layer in a center of the board.

An example in which copper is used as metal of the signal line is described.

In the configuration, an adhesive layer 400 is inserted between PCT and copper, the adhesive layer receives the circuit plating layer 115, and the signal line is completely formed on the base film.

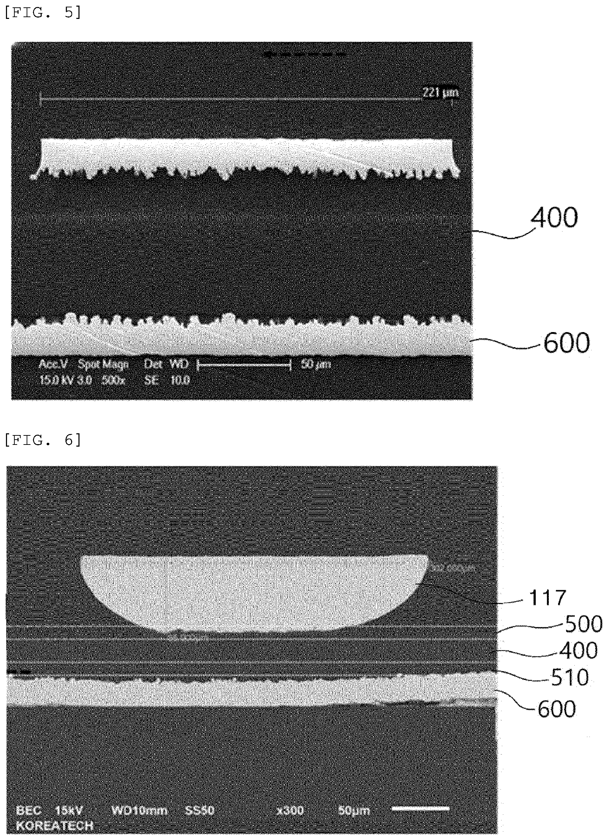

FIG. 5 is a cross-sectional view of the existing actual etched circuit board (FPCB).

In the case of the existing technology for manufacturing PCB, an adhesive surface generally has roughness Ra = 7 $\mu$m to 8 $\mu$m.

These structural characteristics are factors that worsen transmission loss characteristics in a gigahertz ultra-high frequency band.

FIG. 6 illustrates a cross-sectional structure of an actual flexible printed circuit board manufactured by the micro pattern transfer printing (MPTP) process of the present invention. The micro pattern transfer printing (MPTP) method is a method in which the mold pattern surface maintains the roughness Ra suitable for performing transfer at 1 $\mu$m or lower such that the circuit plating layer 115 generated by the electroforming is transferred by the pressing roller 300, thus enabling the upper and lower sections of the signal line to maintain the overall roughness Ra at 1 $\mu$m or lower.

In particular, an upper arch-type section of the signal line can reduce roughness to 0.5 $\mu$m or lower by adjusting an additive in a plating solution, and thus the transmission loss can be further reduced.

Differences in roughness and shape between a circuit manufactured by the existing wet etching and the circuit manufactured by the micro pattern transfer printing (MPTP) process of the present invention can be visually confirmed in FIGS. 5 and 6.

A difference in transmission loss due to a structural difference based on shapes of the cross sections was confirmed through the simulation.

In the existing process, the roughness is increased to enhance the adhesion of the copper foil, and the roughness under this copper foil film becomes one of the main causes of transmission loss of a high-frequency signal.

The roughness Ra of 7 $\mu$m to 8 $\mu$m in the existing technology results in the transmission loss and a signal is not transmitted even at a short distance in a gigahertz frequency range.

In general, a shape formed by the existing process has a quadrangular strip.

As in an equation below, loss of a circuit formed in a quadrangular shape is significantly larger than that of an arch type, and reduction in transmission loss of a signal increases even more as the roughness of the signal line increases.

$$a'C = aC \left[ 1 + \frac{2}{n} \tan^{-1} 1.4 \left( \frac{\Delta}{\delta s} \right)^2 \right]$$

Here, $\alpha C$ represents loss in the case of a perfectly smooth conductor;

$\alpha$'c represents loss with respect to roughness;
$\Delta$ represents RMS roughness; and
$\delta$s represents a depth of a surface layer of a conductor.

The electrical characteristics at an ultra-high frequency with an arch-type structure are as follows.

First, the transmission loss is analyzed through the simulation of a structure having the arch type.

It was confirmed that the transmission loss is reduced due to a correlation between a structure of a cross section and roughness formed by the micro pattern transfer printing (MPTP) process of the present invention.

The flat-cable flexible printed circuit board for ultra-high frequency is manufactured by the flat-cable flexible printed circuit board for ultra-high frequency manufacturing device.

The flexible printed circuit board is a term meaning that a microcircuit line is formed on a substrate made of a soft material.

The following is about a configuration of the flat-cable flexible printed circuit board for ultra-high frequency.

In the configuration, the second metal layer 600 that can transmit a signal can be selected and further formed on the back of the base film 400.

The description according to FIG. 7 is as follows.

In FIG. 7, in the micro pattern transfer printing (MPTP) process of the present invention, a technique of receiving a pattern from the cylindrical mold of micro pattern is used, and thus an upper section of the plating layer is transferred in an arch type.

Here, a ratio of upper and lower sections of a cross section of a circuit pattern signal line that has been plated and transferred was defined as a parameter $\alpha$.

A resulting product obtained by continuously transferring the circuit plating layers 115 to the base film 400 is referred to as the signal line 117.

A plating section obtained by the electroforming from the microcircuit pattern section 160 is referred to as the circuit plating layer 115.

When $\alpha$ becomes 1 as in FIG. 7, the cross section 116 of the circuit plating layer becomes rectangular, and as a value of $\alpha$ decreases, the cross section 116 of the circuit-pattern circuit plating layer has a shape having an upper surface that becomes longer compared to a lower surface thereof.

The smaller the $\alpha$ value, the smaller the transmission loss in the ultra-high frequency range.

The description according to FIG. 8 is as follows.

FIG. 8 is a simulation result graph illustrating whether the transmission loss of the circuit changes depending on variation of $\alpha$ of the cross section of the arch-type circuit-pattern signal line.

As the value of $\alpha$ becomes less than 1, the transmission loss decreases.

The circuit-pattern signal line shape obtained through the existing etching process is close to $\alpha$ = 1, whereas $\alpha$ is decreased using the micro pattern transfer printing (MPTP) process, and thus an effect of reduction in transmission loss can be achieved compared to the existing technologies.

[Table 1]

| Transmission loss (dB/cm) due to change in parameter $\alpha$ | | | |
|---|---|---|---|
| Value of $\alpha$ | 10 GHz | 20 GHz | Notes |
| 1 | 0.266 | 0.468 | |
| 0.9 | 0.265 | 0.467 | |
| 0.8 | 0.264 | 0.464 | |
| 0.7 | 0.260 | 0.455 | |
| 0.6 | 0.254 | 0.447 | |
| 0.5 | 0.245 | 0.423 | |
| 0.4 | 0.234 | 0.402 | |
| 0.3 | 0.227 | 0.393 | Low-loss utilization |
| 0.2 | 0.224 | 0.387 | |
| 0.1 | 0.222 | 0.384 | |

FIG. 8 is a transmission loss graph obtained by performing comparison between 10 GHz and 20 GHz based on the table.

As the frequency band increases, the difference in transmission loss appears to increase, so it can be found that the micro pattern transfer printing (MPTP) process that reduces the parameter $\alpha$ can achieve good performance in an operation in the high-frequency range.

In FIG. 8, a graph curve is bent at a value of $\alpha$ of 0.3.

In the present invention, it can be found that it is preferable to utilize a value of $\alpha$ that is 0.3 or lower.

There are various structures that can be used to transmit a high-frequency signal.

This includes a coaxial cable, a strip line, and a microstrip.

This structure has different cross-section shapes, so the loss characteristics are different.

In the coaxial cable topology of the GHz frequency range, a surface layer effect attracts a current in a surface layer direction of a central conductor, but since the central conductor has a cylindrical shape, a current density has the characteristics of being evenly distributed around the conductor. However, a strip line structure has a ground plane. The strip line having a rectangular cross section induces a magnetic field, thus resulting in a higher current density distribution at an edge and a side (at a corner).

In the case of a thin film, a microstrip structure with a single grounding plane concentrates the current density at a lower side and lower edges of a trace.

Here, roughness of a bottom surface of the conductor affects loss during high-frequency transmission.

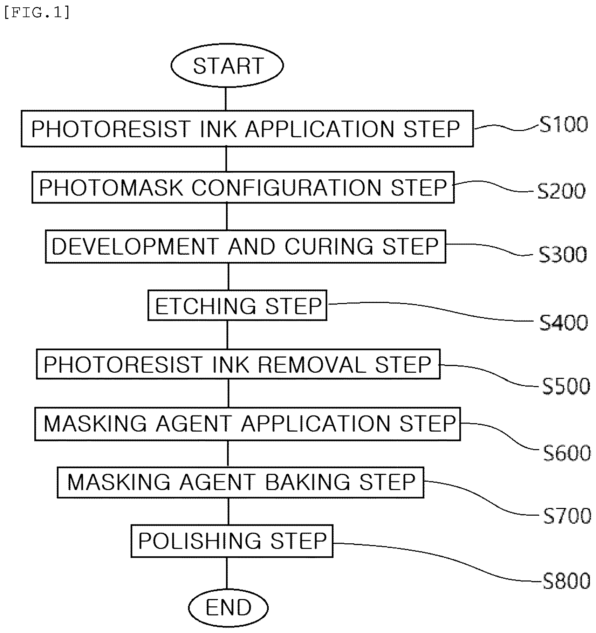

The description according to micro-patterning method according to FIGS. 1 and 2 in detail is as follows.

A method for forming a micro pattern on the cylindrical mold 100 of micro pattern is configured in order to manufacture the flat-cable for ultra-high frequency continuous-manufacturing device.

FIGS. 2A and 2B are to be described in a plate shape for easy understanding of the method for forming a micro pattern on the cylindrical mold of micro pattern.

FIG. 2A describes, in a plane shape, a process of generation on a cylindrical shape.

The following metal plate is continuously formed on the cylindrical mold of micro pattern.

A photoresist ink application step S100 of applying photoresist ink 140 on a metal plate 130 is performed. In the present invention, the metal plate 130 is made of a SUS plate.

After the photoresist ink application step S100, a photomask configuration step S200 of forming the photomask after 150 is performed.

After the photomask configuration step S200, a development and curing step S300 of developing and curing the photoresist by exposure is performed.

After the development and curing step S300, an etching step S400 of etching metal with an etchant in a developed region is performed.

After the etching step S400, a photoresist removal step S500 of removing the cured photoresist is performed.

After the photoresist removal step S500, a masking agent application step S600 of applying a masking agent (referring to the polymer resin part) is performed.

After the masking agent application step 600, a masking agent baking step S700 of baking is performed.

A method for forming a micro pattern on a metal plate including a polishing step S800 of performing polishing while a part of the metal plate 130 in which a microcircuit pattern section 160 is formed is protected after the masking agent baking step S700 is provided.

Here, in the etching step S400, an etching width, an etching depth, and a signal line width are designed and formed through the photo chemical machining (PCM) process.

Here, a precision degree of the cylindrical mold 100 of micro pattern can be improved by the optimized etching process during the photo chemical machining (PCM) process.

In addition, a precise electroforming process and an improvement in a flatness degree and a polishing process can prevent a fine line width from being damaged.

In this way, a metal plate micro pattern formed by the method for forming a metal plate micro pattern is inserted into the cylindrical mold of micro pattern to form the cylindrical mold 100 of micro pattern.

The hardness of the electroforming layer can improve a service life of the metal mold.

The production costs of the FPCB using the micro pattern transfer printing (MPTP) process of the present invention is most affected by a service life of the cylindrical mold 100 of micro pattern.

In addition, the service life of the cylindrical mold 100 of micro pattern is determined by the adhesion between a polymer resin filled in a part other than the micro pattern and the cylindrical mold 100 of micro pattern.

If the plating solution penetrates an interface between the polymer resin and the cylindrical mold 100 of micro pattern due to continuous stress in a continuous plating process and a transfer process, the polymer resin (denoting the masking agent) can peel off to shorten the service life.

The description according to 9A and 9B is as follows.

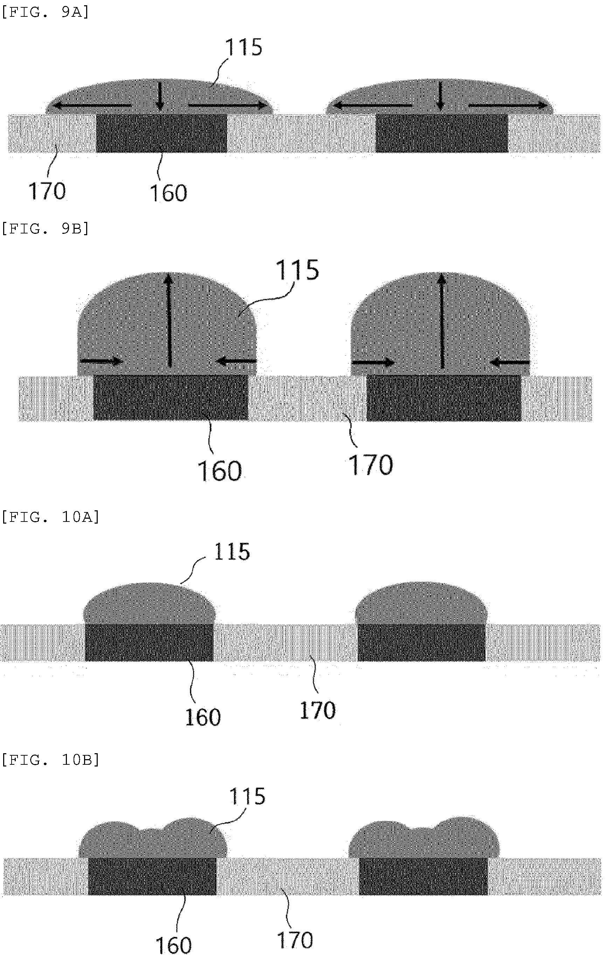

FIG. 9A is a view illustrating a horizontal growth model.

A main purpose is to introduce an appropriate amount of the leveler into the electroforming bath 200 for uniformity of smoothness of the pattern and of the thickness of the plating layer.

In FIG. 9A, when a very large amount of the leveler is put into the electroforming bath 200 during the copper plating of the microcircuit pattern section 160 of the present invention, a plating layer having a line width larger than that of the microcircuit pattern section 160 is formed.

FIG. 9B is a view illustrating the case of vertical growth when a minimum amount of the leveler is applied.

An ellipse-type plating layer is formed by adjusting a plating thickness and through the vertical growth by adjusting the leveler which is an additive in copper plating.

The circuit plating layer 115 is formed by performing the copper plating and is formed by adding the leveler which is a copper plating additive such that a loss rate of the signal line manufactured of the circuit plating layers 115 can be minimized by adjusting the plating thickness.

The low-loss flat-cable signal line for ultra-high frequency is configured to have the arch-type or ellipse-type cross section by adjusting a plating time in the electroforming bath by the flexible printed circuit board manufacturing device.

The description according to FIGS. 10A to 10C is as follows.

FIG. 10A is a view illustrating a shape of a copper plating layer as the circuit plating layer 115 when a low current flows and low-speed rotation is performed in the electroforming bath 200.

FIG. 10B is a view illustrating a shape of a copper plating layer formed by plating conditions when a high current flows and low-speed rotation is performed in the electroforming bath 200.

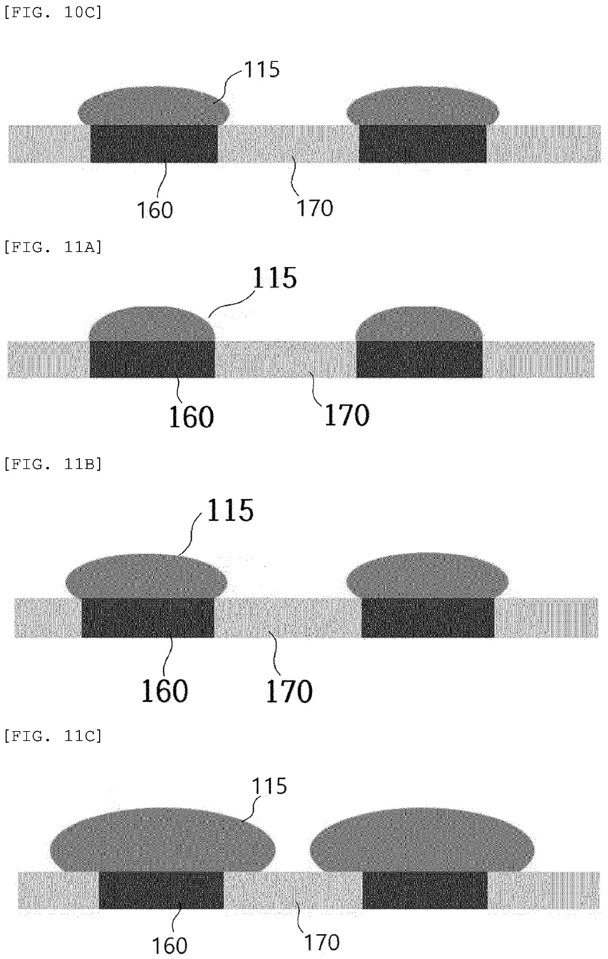

FIG. 10C is a view illustrating a shape of a copper plating layer formed by plating conditions when a high current flows and high-speed rotation of a cylindrical mold of micro pattern is performed in the electroforming bath 200.

The low-loss flat-cable signal line for ultra-high frequency is configured to have the arch-type or ellipse-type cross section by adding a leveler and an additive in the electroforming bath by the flexible printed circuit board manufacturing device.

That is, the method for manufacturing the flat-cable flexible printed circuit board for ultra-high frequency is provided to adjust the value of $\alpha$ to minimize the transmission loss rate of the signal line by forming the signal line through the copper plating to be plated on the microcircuit pattern section 160 by adjusting the arch type or the plating thickness by adding the leveler which is the copper plating additive.

The description according to FIGS. 11A to 11C is as follows.

The drawings are views illustrating shapes of a copper plating growth depending on a plating thickness and time.

FIG. 11A is a view illustrating a shape of the copper plating layer in a case where the thickness of the copper plating layer is 5 $\mu$m to 10 $\mu$m and the plating time is 10 to 15 minutes.

FIG. 11B is a view illustrating a shape of the copper plating layer in a case where the thickness of the copper plating layer is 10 $\mu$m to 20 $\mu$m and the plating time is 20 to 30 minutes.

FIG. 11C is a view illustrating a shape of the copper plating layer in a case where the thickness of the copper plating layer is 30 $\mu$m or larger and the plating time is 30 minutes or longer.

The method for manufacturing the flexible printed circuit board is performed by the flexible printed circuit board manufacturing device of the present invention to allow the circuit plating layer to have the ellipse-type cross section depending on a magnitude of a current flowing in the electroforming bath 200 and a rotation speed of the cylindrical mold of micro pattern.

The configurations that affect the transmission loss are as follows.

The transmission loss is measured for each type of base films, with a circuit width of 250 $\mu$m and a length of 25 cm. The transmission loss per film is shown in Table 2.

[Table 2]

| Transmission loss for each film type (dB/cm) | | |
|---|---|---|
| Film types | Measured value of the transmission loss | Note |
| PCT | 0.47116 | Circuit width: 250 $\mu$m |
| PEN | 0.5672 | Coupon length: 25 cm |

The frequency is a measured value of the transmission loss at 10 GHz.

Table 3 illustrates a low dielectric adhesive that has an average thickness of 39.3 $\mu$m, and a dielectric constant and transmission loss for each frequency. The unit of transmission loss is (dB/cm).

[Table 3]

| Transmission loss due to adhesive (dB/cm) | | |
|---|---|---|
| Low dielectric-type adhesive HE-66A (average thickness: 39.3 $\mu$m) | | |
| Frequency | 5 GHz | 10 GHz |
| Dielectric constant (Dk) | 2.34848 | 2.24795 |
| Transmission loss (Df) | 0.005 | 0.00485 |

Table 4 illustrates roughness of the plating growth surface and the mold pattern surface corresponding to the signal line in the present invention.

[Table 4]

| Roughness | | |
|---|---|---|
| | Plating growth surface | Mold pattern surface |
| Ra | 0.234 | 0.836 |
| Rmax | 2.73 | 13.93 |
| Rz | 2.2 | 9.66 |
| Ra: Average roughness<br>An average value of all peaks and valleys that deviate from an average line of the total reference length in the roughness curve is used as the roughness.<br>Rmax: Maximum height roughness<br>A vertical distance from the highest peak to the deepest valley on the cross-sectional curve is used as roughness.<br>Rz: Ten-point average roughness | | |

A difference between an average height of the five highest peaks and an average depth of five deepest valleys is used as average roughness.
A unit of the roughness is $\mu$m.
The transmission loss for each frequency in the PCT base film is as described in Table 5 below.

[Table 5]

| Transmission loss for each frequency band | | | | | |
|---|---|---|---|---|---|
| Film Type | Thickness (mm) | Dk | | Df | |
| | | 100 MHz | 2 GHz | 100 MHz | 2 GHz |
| PCT | 0.51 | 2.39 | 2.29 | 0.0056 | 0.0068 |

Dk represents dielectric constant, and Df denotes transmission loss.
A term or a word used in this specification or claims is not construed as a limited meaning of a common or dictionary meaning but has to be construed as a meaning and a concept corresponding to the technical ideas of the present invention on the basis of the principle that an inventor can define a concept of a term in order to describe his or her invention in the best way, as appropriate.
Hence, since each example described in this specification and each configuration depicted in the drawings are provided only as the most preferred example of the present invention and do not represent all of the technical ideas of the present invention, it needs to be construed that there can be various equivalents and modification examples which can substitute for the examples and the configurations of the present invention at the time of this application.

[Industrial Applicability]

The present invention belongs to a field in which, among components applied to electric vehicles, a cable harness used for power and signal transmission improves lightweight design and space-saving, and thus being industrially applicable.
The present invention has an effect in that a thickness or a shape of a cross section of a signal line can be adjusted to be suitable for product characteristics and various materials such as copper and alloys can be selected as a material of the signal line, thus being applicable to industrial fields.

In addition, a circuit cross section of the signal line of the present invention has an advantage in that transmission loss can be reduced in a high-frequency band, thus being industrially applicable.

In addition, the present invention has effects in that a flexible printed circuit board having a long circuit length can be manufactured and is applicable to various technical fields, thus being industrially applicable.

**Claims**

1. A low-loss flat-cable signal line for ultra-high frequency manufactured to have an arch-type or ellipse-type cross section of a circuit plating layer plated on a microcircuit pattern section formed on a cylindrical mold of micro pattern provided in an electroforming bath.

2. The low-loss flat-cable signal line for ultra-high frequency according to claim 1, wherein the circuit plating layer has the arch-type or ellipse-type cross section, and a ratio ($\alpha$ = a/b) of a line width a of the microcircuit pattern section to an electroformed line width b is 0.3 or lower.

3. The low-loss flat-cable signal line for ultra-high frequency according to claim 2, wherein the electroformed line width b is 10 $\mu$m to 500 $\mu$m, and roughness Ra is 1 $\mu$m or lower.

4. A low-loss flat-cable signal line for ultra-high frequency configures;

   a cross section of a circuit plating layer plated on a microcircuit pattern section formed on a cylindrical mold of micro pattern provided in an electroforming bath is ellipse-type,
   a thickness of the cross section of the circuit plating layer is defined as a distance h from a surface of the cylindrical mold of micro pattern to an upper end of the cross section of the circuit plating layer, and
   in a case where a length from a front surface of the cylindrical mold of micro pattern to a major axis of an ellipse is defined as h2, and a distance from the major axis of the ellipse to the upper end of the cross section of the circuit plating layer is defined as h1, a ratio of h1/h2 is between 0.5 and 1.

5. The low-loss flat-cable signal line for ultra-high frequency according to claim 4, wherein the distance h from the surface of the cylindrical mold of micro pattern to the upper end of the cross section of the circuit plating layer is 5 $\mu$m to 100 $\mu$m, and roughness Ra is 1 $\mu$m or lower.

6. A flat-cable flexible printed circuit board for ultra-high frequency having a microstrip structure in which the low-loss flat-cable signal line for ultra-high frequency according to any one of claims 1 to 5 is bonded to a base film, and a metal layer(ground) having a grounding function is attached to a back surface of the base film to which the low-loss flat-cable signal line for ultra-high frequency is attached.

7. A flat-cable flexible printed circuit board for ultra-high frequency continuous-manufacturing device, wherein, in order to manufacture the flat-cable flexible printed circuit board for ultra-high frequency according to claim 6, the cylindrical mold of micro pattern is partially submerged in the electroforming bath, the circuit plating layer is plated on the microcircuit pattern section, and plated the low-loss flat-cable signal line for ultra-high frequency is transferred and printed onto the base film by passing, between the cylindrical mold of micro pattern and a pressing roller, the base film on which an adhesive is applied.

8. A method for manufacturing a flat-cable flexible printed circuit board for ultra-high frequency, wherein the low-loss flat-cable signal line for ultra-high frequency is configured to have an arch-type or ellipse-type cross section depending on a magnitude of a current flowing in the electroforming bath and a rotation speed of the cylindrical mold of micro pattern by the flat-cable flexible printed circuit board for ultra-high frequency continuous-manufacturing device according to claim 7.

9. A method for manufacturing a flat-cable flexible printed circuit board for ultra-high frequency, wherein the low-loss flat-cable signal line for ultra-high frequency is configured to have an arch-type or ellipse-type cross section by adding a leveler and an additive in the electroforming bath by the flat-cable flexible printed circuit board for ultra-high frequency continuous-manufacturing device according to claim 7.

10. A method for forming a micro pattern on a cylindrical mold of micro pattern, in which a micro pattern is formed on the cylindrical mold of micro pattern by a photo chemical machining (PCM) process in order to manufacture the flat-cable flexible printed circuit board for ultra-high frequency continuous-manufacturing device according to claim 7, the method comprising:

a photoresist ink application step of applying photoresist ink on a metal plate;

a photomask configuration step of forming a photomask after the photoresist ink application step;

a development and curing step of developing and curing a photoresist by exposure after the photomask configuration step;

an etching step of etching metal with an etchant in a developed region after the development and curing step;

a photoresist removal step of removing the cured photoresist after the etching step;

a masking agent application step of applying a masking agent after the photoresist removal step;

a masking agent baking step of baking the masking agent after the masking agent application step; and

a polishing step of performing polishing while a part of the metal plate in which a microcircuit pattern section is formed is protected, after the masking agent baking step.

[FIG.1]

START

PHOTORESIST INK APPLICATION STEP —S100

PHOTOMASK CONFIGURATION STEP —S200

DEVELOPMENT AND CURING STEP —S300

ETCHING STEP —S400

PHOTORESIST INK REMOVAL STEP —S500

MASKING AGENT APPLICATION STEP —S600

MASKING AGENT BAKING STEP —S700

POLISHING STEP —S800

END

[FIG. 2A]

S100 — 140
130

S200 — 150

S300

S400

S500

S600

S700 — 170
160

S800

[FIG. 2B]

160  170  100

[FIG. 3A]

[FIG. 3B]

[FIG. 3C]

[FIG. 3D]

[FIG. 3E]

[FIG. 4A]

[FIG. 4B]

[FIG. 4C]

EM simulation setup

Using CAD tool: Ansys Electornics 2021 R1(HFSS)

217 $\mu m$

Changed according to α

[FIG. 4D]

Cu 18 um

Adhesive 25 um

PCT 50 um

Adhesive 5 um

Cu 18 um(ground)

[FIG. 5]

[FIG. 6]

[FIG. 7]

[FIG. 8]

[FIG. 9A]

115

170    160

[FIG. 9B]

115

160    170

[FIG. 10A]

115

160    170

[FIG. 10B]

115

160    170

[FIG. 10C]

[FIG. 11A]

[FIG. 11B]

[FIG. 11C]

[FIG. 12]

## INTERNATIONAL SEARCH REPORT

| | International application No. |
|---|---|
| | **PCT/KR2023/006851** |

**A.    CLASSIFICATION OF SUBJECT MATTER**

**H01B 7/08**(2006.01)i; **H05K 1/14**(2006.01)i; **H01B 13/00**(2006.01)i

According to International Patent Classification (IPC) or to both national classification and IPC

**B.    FIELDS SEARCHED**

Minimum documentation searched (classification system followed by classification symbols)

H01B 7/08(2006.01); B29C 59/04(2006.01); B82B 3/00(2006.01); C25D 1/10(2006.01); C25D 17/12(2006.01); G03F 7/00(2006.01); H01B 1/02(2006.01); H01B 13/008(2006.01); H05K 3/18(2006.01); H05K 3/24(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 도금(plating), 원통형(cylindrical), 회로몰드(circuit mold), 패턴(pattern), 아크형상(arc shape), 플랫케이블 신호선(plate cable signal line), 초고주파(super high frequency)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2020-0064614 A (SAMWON ACT CO., LTD.) 08 June 2020 (2020-06-08)<br>See paragraph [0015]; and figures 1-2. | 1-10 |
| A | KR 10-2011-0034401 A (EMOT CO., LTD.) 05 April 2011 (2011-04-05)<br>See paragraph [0063]; claim 9; and figures 2 and 4. | 1-10 |
| A | KR 10-2005-0095742 A (KOREA ADVANCED INSTITUTE OF SCIENCE AND TECHNOLOGY) 30 September 2005 (2005-09-30)<br>See claim 1. | 1-10 |
| A | KR 10-2020-0062141 A (KOREA INSTITUTE OF MACHINERY & MATERIALS) 03 June 2020 (2020-06-03)<br>See paragraphs [0046]-[0109]; and figures 3-16. | 1-10 |
| A | KR 10-2019-0107263 A (FEEL THE SAME, INC.) 19 September 2019 (2019-09-19)<br>See paragraphs [0016]-[0037]; and figure 1. | 1-10 |

| ☐ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 August 2023** | **25 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/006851**

| Patent document cited in search report | | | Publication date (day/month/year) | Patent family member(s) | | | Publication date (day/month/year) |
|---|---|---|---|---|---|---|---|
| KR | 10-2020-0064614 | A | 08 June 2020 | EP | 3890458 | A1 | 06 October 2021 |
| | | | | JP | 2022-510952 | A | 28 January 2022 |
| | | | | JP | 7178749 | B2 | 28 November 2022 |
| | | | | KR | 10-2152892 | B1 | 07 September 2020 |
| | | | | US | 2022-0010445 | A1 | 13 January 2022 |
| | | | | WO | 2020-111751 | A1 | 04 June 2020 |
| KR | 10-2011-0034401 | A | 05 April 2011 | KR | 10-1132339 | B1 | 05 April 2012 |
| KR | 10-2005-0095742 | A | 30 September 2005 | CN | 1673870 | A | 28 September 2005 |
| | | | | KR | 10-0533316 | B1 | 02 December 2005 |
| | | | | US | 2005-0214195 | A1 | 29 September 2005 |
| KR | 10-2020-0062141 | A | 03 June 2020 | KR | 10-2019-0058259 | A | 29 May 2019 |
| | | | | KR | 10-2019-0058260 | A | 29 May 2019 |
| | | | | KR | 10-2109913 | B1 | 12 May 2020 |
| | | | | KR | 10-2117840 | B1 | 03 June 2020 |
| | | | | KR | 10-2330451 | B1 | 24 November 2021 |
| | | | | US | 11656545 | B2 | 23 May 2023 |
| | | | | US | 2020-0355998 | A1 | 12 November 2020 |
| | | | | WO | 2019-098705 | A1 | 23 May 2019 |
| KR | 10-2019-0107263 | A | 19 September 2019 | CN | 110431516 | A | 08 November 2019 |
| | | | | CN | 110431516 | B | 23 May 2023 |
| | | | | KR | 10-2019-0100569 | A | 29 August 2019 |
| | | | | KR | 10-2019-0110169 | A | 30 September 2019 |
| | | | | KR | 10-2019-0119702 | A | 23 October 2019 |
| | | | | KR | 10-2020-0052254 | A | 14 May 2020 |
| | | | | KR | 10-2041605 | B1 | 07 November 2019 |
| | | | | KR | 10-2107828 | B1 | 08 May 2020 |
| | | | | KR | 10-2123534 | B1 | 17 June 2020 |
| | | | | KR | 10-2159699 | B1 | 28 September 2020 |
| | | | | KR | 10-2215651 | B1 | 17 February 2021 |
| | | | | KR | 10-2262157 | B1 | 10 June 2021 |
| | | | | KR | 10-2289978 | B1 | 18 August 2021 |
| | | | | KR | 10-2289978 | B9 | 27 October 2021 |
| | | | | US | 10908685 | B2 | 02 February 2021 |
| | | | | US | 11301042 | B2 | 12 April 2022 |
| | | | | US | 2020-0089320 | A1 | 19 March 2020 |
| | | | | US | 2021-0116999 | A1 | 22 April 2021 |
| | | | | WO | 2019-164106 | A1 | 29 August 2019 |

Form PCT/ISA/210 (patent family annex) (July 2022)